# EUROPEAN PATENT SPECIFICATION

(11) **EP 1 280 275 B1**
(45) Date of publication and mention of the grant of the patent: **19.09.2007**
(21) Application number: 02016121.2
(22) Date of filing: 19.07.2002
(51) Int. Cl.: H03J 7/18, H04N 5/46

(54) **Automatic tuning apparatus**
Automatische Abstimmungsvorrichtung
Dispositif d'accord automatique

(30) Priority: 19.07.2001 JP 2001220073
(43) Date of publication of application: 29.01.2003
(73) Proprietor: Pioneer Corporation, Meguro-ku, Tokyo (JP)
(72) Inventor: Shibata, Koji, Kawageo Koujou, Kawagoe-shi, Saitama-ken 350-8555 (JP); Uchiyama, Kazuhiko, Kawageo Koujou, Kawagoe-shi, Saitama-ken 350-8555 (JP)
(74) Representative: Popp, Eugen

(56) References cited:
- EP-A- 0 576 797
- EP-A- 0 664 645
- WO-A-00/70868
- US-A- 5 557 337
- US-A- 5 636 250

## Description

The present invention relates to an automatic tuning apparatus for performing automatic tuning within frequency bands where digital broadcast waves and analog broadcast waves, such as digital and analog television broadcast waves, lie in mixture.

In recent years, research and development has been conducted of integrated service digital broadcasting (ISDB) in which information including pictures, sounds, and data is handled as digital data. Digital television broadcasting, digital audio broadcasting, multimedia broadcasting, and the like using this integrated service digital broadcasting are under research and development, and broadcasts thereof are in practical use.

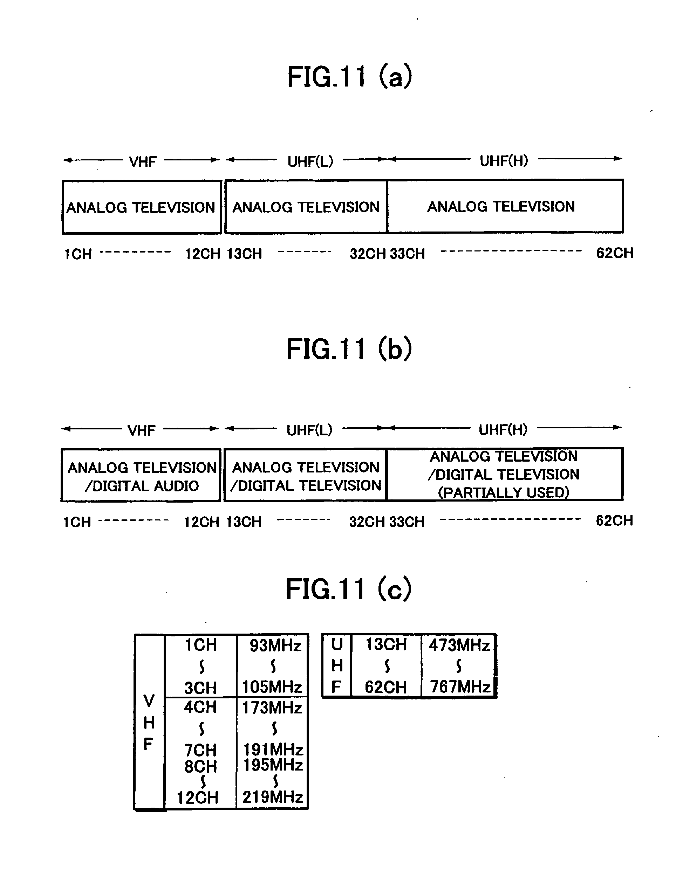

Here, with reference to Figs. 11(a) and 11(b), description will be given of a difference between the analog television broadcasting heretofore prevalent in our country and the integrated service digital broadcasting.

As schematically shown in Fig. 11(a), the analog television broadcasting heretofore prevalent in our country uses a VHF frequency band and UHF frequency bands.

The VHF frequency band is allocated for physical channels of 1st to 12th channels (1CH to 12CH). The lower UHF frequency band UHF(L) is allocated for physical channels of 13th to 32nd channels (13CH to 32CH). The higher UHF frequency band UHF(H) is allocated for physical channels of 33rd to 62nd channels (33CH to 62CH).

The individual physical channels from the 1st channel (1CH) to the 62nd channel (62CH) are given a frequency band of 6 MHz each, with some exceptions. The 6-MHz frequency bands correspond to the channel numbers assigned to respective television broadcast stations. Each television broadcast station then transmits a single analog television signal which occupies almost the entire 6-MHz frequency band of the 6-MHz physical channel assigned.

Meanwhile, the integrated service digital broadcasting, as shown in Fig. 11(b), establishes physical channels capable of transmitting digital television broadcasts by using the same transmission bands as those of the conventional analog television broadcasting described above.

In Fig. 11(b), the VHF frequency band is allocated for physical channels of 1st to 12th channels (1CH to 12CH). The lower UHF frequency band UHF(L) is allocated for physical channels of 13th to 32nd channels (13CH to 32CH). The higher UHF frequency band UHF(H) is allocated for physical channels of 33rd to 62nd channels (33CH to 62CH). Then, the individual physical channels from the 1st channel (1CH) to the 62nd channel (62CH) are given a frequency band of 6 MHz each, with some exceptions.

It should be noted here that the integrated service digital broadcasting further allocates unit segments of 0.4 MHz in frequency band to each of the physical channels having a frequency band of 6 MHz so that one up to thirteen unit segments can be used for data transmission.

Then, television broadcast stations to which physical channels are assigned transmit digital television signals with thirteen unit segments as a unit, in accordance with the physical channels as with the conventional analog television broadcasting. As shown in Fig. 11(b), all of the physical channels in the lower UHF frequency band UHF(L) and some of the physical channels in the higher UHF frequency band UHF(H) are allocated for digital television broadcasting.

In the integrated service digital broadcasting, one up to thirteen unit segments are regarded as a single unit. When each single unit establishes a channel for digital audio broadcasting, one or more channels of digital audio broadcasts can be transmitted within each physical channel having a frequency band of 6 MHz. As shown in Fig. 11(b), the physical channels in the VHF frequency band are allocated for digital audio broadcasting.

As stated previously, the physical channels of the integrated service digital broadcasting and those of the conventional analog television broadcasting are both assigned to frequency bands in steps of 6 MHz. Hence, a physical channel of the integrated service digital broadcasting can also transmit a single analog television signal which occupies almost an entire 6-MHz frequency band.

This makes the integrated service digital broadcasting a system capable of transmitting not only the aforementioned digital audio broadcasts and digital television broadcasts but also analog television signals of the conventional system, or equivalently, a so-called compatible system.

Then, all the physical channels in the VHF and UHF frequency bands are allocated for analog television broadcasting. It is therefore possible to select which to use each identical physical channel for analog television broadcasting, digital audio broadcasting, or digital television broadcasting.

Incidentally, the foregoing physical channels (1CH to 62CH) have carrier frequencies determined as shown in Fig. 11(c).

As has been described, the integrated service digital broadcasting, because of being a system conforming to the digital audio broadcasting, digital television broadcasting, and analog television broadcasting, allows mixture of digital broadcasts and analog broadcasts in the 62 physical channels (1CH to 62CH).

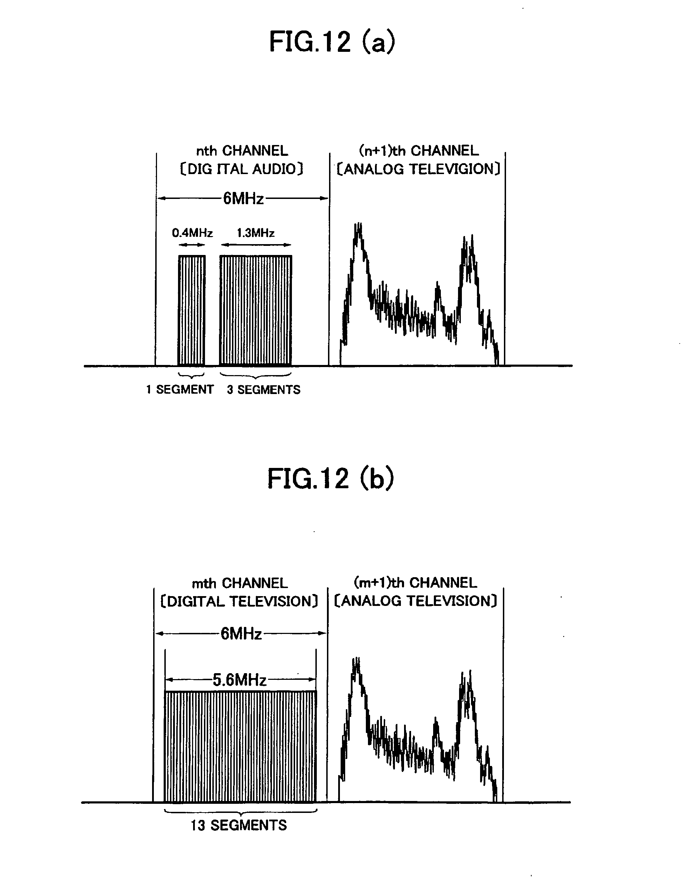

For example, as shown in Fig. 12(a), a physical channel (nth channel) lying within the VHF frequency band transmits a digital audio broadcast using a single unit segment as a unit and a digital audio broadcast using three unit segments as a unit, i.e., two channels of digital audio broadcasts through the single physical channel. An adjoining physical channel ((n + 1)th channel) transmits an analog television signal of the conventional system which occupies almost the entire 6-MHz frequency band. Such digital-and-analog mixture within the same broadcast band (VHF frequency band) is allowed.

Otherwise, as shown in Fig. 12(b), a physical channel (m th channel) lying within an UHF frequency band may transmit a digital television broadcasting using thirteen unit segments as a unit while an adjoining physical channel ((m + 1)th channel) transmits an analog television broadcast of the conventional system which occupies almost the entire 6-MHz frequency band. Such digital-and-analog mixture within the same broadcast band (UHF frequency band) is also allowed.

By the way, on the side of receivers for receiving the broadcast waves of the integrated service digital broadcasting, automatic tuning in search for the channels of receivable broadcast stations has been effected by performing seeks segment by segment to determine well-receivable broadcast waves.

For example, to search for a receivable channel next to the one tuned currently, individual segments have been subjected to determination in order from lower to higher frequencies for seek. Moreover, in auto presetting to search for and register well-receivable channels within the range of the 1st physical channel (1CH) and the 62nd physical channel (62CH), the method of subjecting individual segments to determination in order from lower to higher frequencies for seeks and then repeating this seek processing has been adopted.

The automatic tuning method of searching for the channels of receivable broadcast stations in the foregoing conventional receivers, however, has had the problem that longer seek time is required for finding the channels of receivable broadcast stations since the individual segments assigned to each physical channel undergo seeks.

More specifically, in seeking a receivable channel next to the one tuned currently, a number of segments assigned between the currently-tuned channel to the next receivable one are checked for reception of a broadcast wave, for example, from lower to higher frequencies in order. This has caused the problem of longer seek time.

Besides, in the auto presetting, the range extending between the first segment of the 1st physical channel (1CH) and the thirteenth segment of the 62nd physical channel (62CH) must be searched for a plurality of well-receivable channels, repeating seeks a plurality of times. Accordingly, there has been the problem that the time to elapse before the completion of the auto presetting increases as the foregoing seek time becomes longer.

Further information pertaining to the prior art can be found in WO 00/70868 that relates to an automatic tuning apparatus as recited in the preamble of claim 1. Specifically, WO 00/70868 teaches a receiver requiring only a single IF SAW filter and IF amplifier receives signals in both analog format and in digital format, such as the NTSC, PAL and SECAM analog television signal formats and the ATSC and DVB digital television signal formats. IF signals from the IF amplifier are sub-sampled to digital signal form and are processed by respective analog format and digital format processors. Control circuitry responsive to the presence of certain unique components of the signals in analog format and digital format determine which of the analog format and digital format processors is producing valid data and selects the valid data to be utilized. In a television receiver, the unique components of the signals may include carrier signals, synchronization signals, pilot signals and symbol timing, and valid data is applied to a television display.

### SUMMARY OF THE INVENTION

The present invention has been achieved in view of the conventional problems. It is thus an object of the present invention to provide an automatic tuning apparatus for performing automatic tuning within frequency bands where digital and analog broadcast waves lie in mixture, the automatic tuning apparatus being capable of automatic tuning in a short time.

The present invention provides an automatic tuning apparatus in accordance with independent claim 1. Preferred embodiments of the invention are reflected in the dependent claims.

To achieve the foregoing object, the present invention provides an automatic tuning apparatus for receiving analog broadcast waves assigned to predetermined frequency bands of respective physical channels corresponding to a plurality of broadcast stations and digital broadcast waves assigned to a plurality of narrow frequency bands, and tuning to a broadcast station covered by the digital broadcast waves, the frequency bands being divided into the narrow frequency bands in units of segments corresponding to a plurality of broadcast stations, characterized in that the apparatus comprising: inherent signal detecting means for detecting the presence or absence of an inherent signal of analog broadcast waves; tuning means for tuning to digital broadcast waves in units of the segments; and control means for controlling the tuning means in accordance with the result of detection of the inherent signal detecting means, wherein the inherent signal detecting means performs the detection of the inherent signal only on the segments containing the inherent signal within the physical channels, and the control means controls the tuning means to perform tuning operations in a physical channel containing no analog broadcast wave based on the result of detection of the inherent signal detecting means.

According to the automatic tuning apparatus of such configuration, the inherent signal detecting means, when detecting the inherent signal to be included in analog broadcast waves during automatic tuning, makes the tuning means perform tuning operations in a physical channel which contains no analog broadcast wave. That is, the physical channels from which the inherent signal is detected are intended for analog broadcast waves. Thus, starting tuning operations in a physical channel containing no analog broadcast wave yields such effects as a reduction in the time required for tuning.

To achieve the foregoing object, the automatic tuning apparatus of the present invention is also characterized in that the control means controls the tuning means to perform tuning operations from the segment lying at an end of the physical channel.

According to the automatic tuning apparatus of such configuration, tuning operations in a physical channel containing no analog broadcast wave are performed from the segment which lies at an end of the physical channel. Consequently, each segment undergoes the tuning, whereby a broadcast station or stations of digital broadcast waves are tuned in. Moreover, when the inherent signal mentioned above is detected, tuning operations in a physical channel containing no analog broadcast wave are started to tune to a broadcast station or stations of digital broadcast waves. This yields such effects as a reduction in the time required for tuning to a broadcast station or stations of digital broadcast wave.

To achieve the foregoing object, the automatic tuning apparatus of the present invention is also characterized in that when the tuning means completes tuning operations on all the segments within a predetermined physical channel, the inherent signal detecting means directs the detection to a physical channel adjoining to the physical channel.

According to such configuration, when tuning is completed of a physical cannel and directed to the next physical channel, the inherent signal detecting means initially detects whether or not the next physical channel contains the inherent signal to be included in analog broadcast waves. If the inherent signal is detected, yet another physical channel is subjected to tuning operations. Consequently, the next physical channel is prevented from being entirely subjected to the detection from the beginning, with such effects as a reduction in the time required for tuning. This yields such achievements as a reduction in the time required for tuning to a broadcast station or stations of digital broadcast waves.

To achieve the foregoing object, the automatic tuning apparatus of the present invention is also characterized in that the inherent signal detecting means, when detecting that a physical channel to be detected contains the inherent signal, directs the detection to a physical channel adjoining to the physical channel to be detected.

According to such configuration, the inherent signal detecting means, when detecting from a physical channel the inherent signal to be included in analog broadcast waves, subjects a physical channel adjoining to the physical channel to the next detection. That is, when the inherent signal is detected from a physical channel, tuning operations are performed on an adjoining physical channel, with such effects as a reduction in the time required for tuning. This yields such achievements as a reduction in the time required for tuning to a broadcast station or stations of digital broadcast waves.

### BRIEF DESCRIPTION OF DRAWINGS

Fig. 1 is a block diagram showing the configuration of an automatic tuning apparatus according to an embodiment;
Fig. 2 is a block diagram showing a configuration example of the segment selecting band pass filter arranged in the automatic tuning apparatus;
Figs. 3(a) and 3(b) are diagrams for explaining a difference between analog television broadcast waves and digital television and digital audio broadcast waves;
Fig. 4 is a chart showing criteria for the control unit arranged in the automatic tuning apparatus;
Fig. 5 is a flowchart showing an operation of automatic tuning by the automatic tuning apparatus of the present embodiment;
Fig. 6 is a flowchart showing another operation of automatic tuning by the automatic tuning apparatus of the present embodiment;
Fig. 7 is a diagram showing the relation between an analog television broadcast wave and segments;
Fig. 8 is a diagram schematically showing the operation for the case where synchronizing signals of analog television broadcast waves are detected in automatic tuning;
Fig. 9 is a diagram schematically showing the operation for the case where a digital television broadcast wave undergoes station detection in automatic tuning;
Fig. 10 is a diagram schematically showing the operation for the case where no broadcast wave is detected in automatic tuning;
Figs. 11(a)-11(c) are diagrams for explaining the frequency bands and channel numbers in the integrated service digital broadcasting and a conventional method of automatic tuning; and
Figs. 12(a) and 12(b) are diagrams showing the situations where digital audio broadcast waves and a digital television broadcast lie with an analog television broadcast wave in the integrated service digital broadcasting, respectively.

### DETAILED DESCRIPTION OF THE PREFERRED EMBODIMENTS

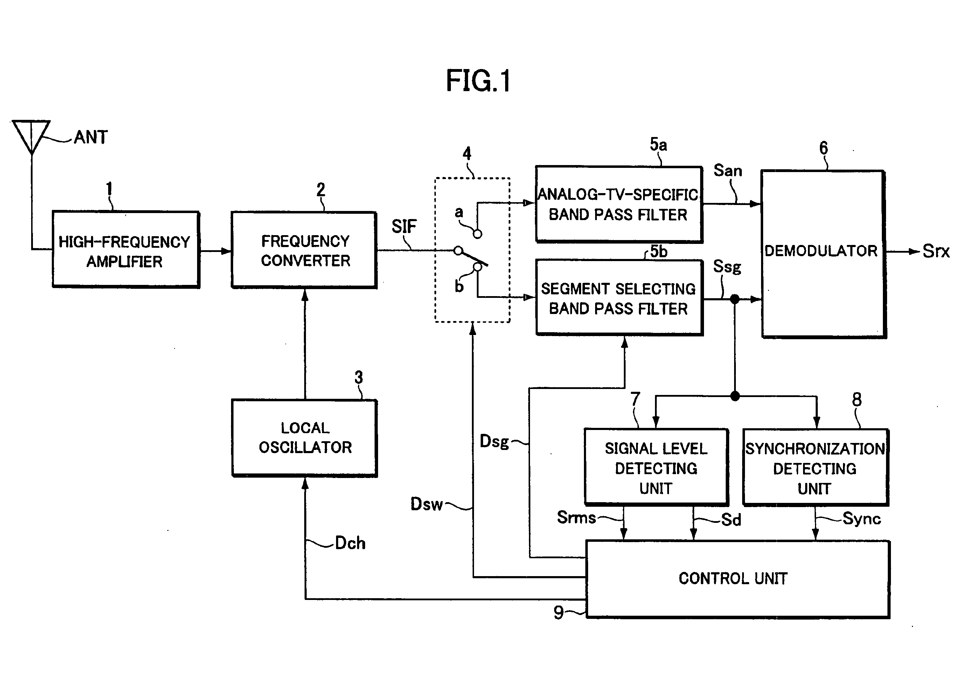

Hereinafter, an embodiment of the present invention will be described with reference to the drawings. Fig. 1 is a block diagram showing the configuration of an automatic tuning apparatus for performing automatic tuning according to the integrated service digital broadcasting an overview of which has been given in conjunction with Figs. 11(a)-12(b). That is, it is a block diagram showing the configuration of an automatic tuning apparatus for performing automatic tuning within frequency bands where digital audio broadcast waves and digital television broadcast waves, or digital broadcast waves, and analog television broadcast waves, or analog broadcast waves, lie in mixture.

The following provides in advance the definitions of automatic tuning for the automatic tuning apparatus to perform. The processing of seeking a receivable channel next to the one tuned currently will be referred to as "next tuning," and the processing of searching for and registering receivable channels out of all the channels as "auto presetting." The "next tuning" and "auto presetting" will be collectively called "automatic tuning."

In Fig. 1, the automatic tuning apparatus receives an incoming wave at an antenna ANT. A high-frequency reception signal output from the antenna ANT is amplified by a high-frequency amplifier 1, and converted in frequency by a frequency converter 2 into an intermediate-frequency signal SIF for output.

More specifically, under the instruction of a channel select signal Dch from a control unit 9 to be described later, a local oscillator 3 outputs a local oscillating signal having a predetermined frequency. The frequency converter 2 detects a mixture of the local oscillating signal and the high-frequency reception signal amplified in the high-frequency amplifier 1, and thereby outputs the intermediate-frequency signal SIF which has the frequency band (6 MHz) of a physical channel corresponding to the frequency of the local oscillating signal.

The automatic tuning apparatus also comprises a switching circuit 4, an analog-TV-specific band pass filter 5a, a segment selecting band bass filter 5b, a demodulator 6, a signal level detecting unit 7, a synchronization detecting unit 8, and the control unit 9.

The switching circuit 4 switches between contacts a and b according to a switch control signal Dsw from the control unit 9. The intermediate-frequency signal SIF is thereby supplied to the analog-TV-specific band pass filter 5a or the segment selecting band pass filter 5b.

Incidentally, in the automatic tuning to be described later, the switching circuit 4 switches to the contact b under the instruction from the control unit 9, so that the segment selecting band pass filter 5b is supplied with the intermediate-frequency signal SIF which is obtained from an analog television broadcast wave, digital audio broadcast wave, or digital television broadcast wave.

To receive an analog television broadcast wave under the instruction from the control unit 9 after the completion of the automatic tuning, the switching circuit 4 switches to the contact a to supply the analog-TV-specific band pass filter 5a with the intermediate-frequency signal SIF which is obtained from the analog television broadcast wave.

To receive a digital television broadcast wave or digital audio broadcast wave under the instruction from the control unit 9 after the completion of the automatic tuning, the switching circuit 4 switches to the contact b. The segment selecting band pass filter 5b is thereby supplied with the intermediate-frequency signal SIF which is obtained from the digital television broadcast wave or digital audio broadcast wave.

The analog-TV-specific band pass filter 5a consists of a band pass filter having a pass frequency band of approximately 6 MHz which corresponds to the frequency band of a physical channel. When supplied with the intermediate-frequency signal SIF through the switching circuit 4, the analog-TV-specific band pass filter 5a removes noise components from the intermediate-frequency signal SIF with the foregoing pass frequency band. The resultant of the noise component removal, or an intermediate-frequency signal San, is supplied to the demodulator 6.

The segment selecting band pass filter 5b comprises narrow-band-pass type band pass filters for dividing the intermediate-frequency signal SIF having a frequency band of 6 MHz into segments (namely, 0.4-MHz frequency bands). The segment selecting band pass filter 5b outputs an intermediate-frequency signal Ssg (hereinafter, referred to as a segment signal) corresponding to a single segment.

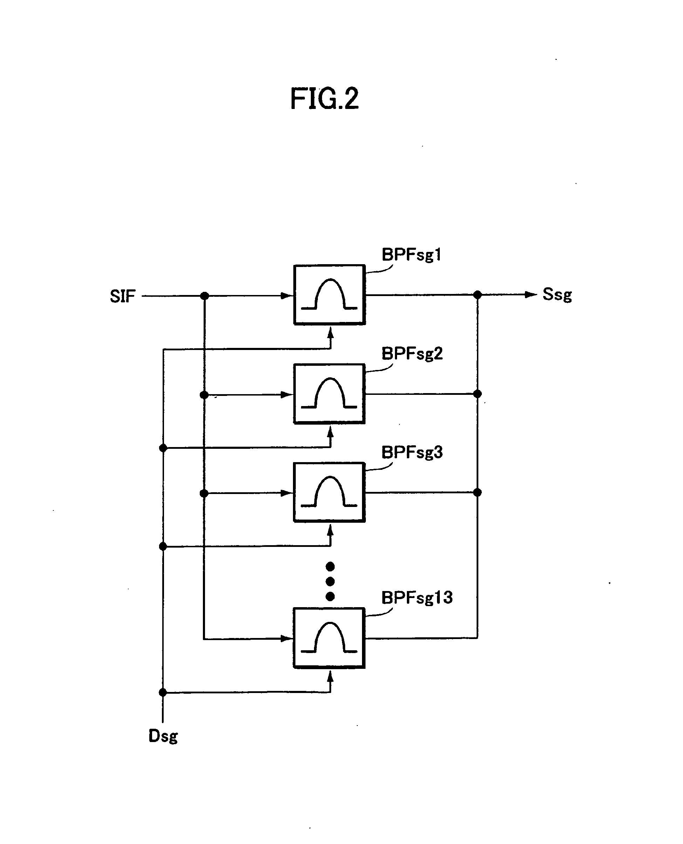

More specifically, as illustrated in Fig. 2, the segment selecting band pass filter 5b consists of 13 narrow-band-pass type band pass filters BPFsg1-BPFsg13 having pass frequency bands in steps of 0.4 MHz. One out of the narrow-band-pass type band pass filters which is designated by a segment select signal Dsg from the control unit 9 is exclusively turned on, so that a segment signal Ssg corresponding to the single segment designated is separated from the intermediate-frequency signal SIF for output.

Consequently, given that the band pass filter BPFsg1 is selected by the segment select signal Dsg, the segment signal Ssg corresponding to the first segment is output out of the intermediate-frequency signal SIF having a frequency band of 6 MHz. When the band pass filter BPFsg2 is selected, the segment signal Ssg corresponding to the second segment is output out of the intermediate-frequency signal SIF of 6 MHz in frequency band. Likewise, when any one of the remaining band pass filters BPFsg3-BPFsg13 is selected, the segment signal Ssg corresponding to the third to thirteenth segment is output exclusively.

Note that the configuration of the segment selecting band pass filter 5b shown in Fig. 2 is merely an embodiment and may be replaced with other configurations. For example, a variable band pass filter of narrow-band-pass type having a pass frequency band of 0.4 MHz may be provided. In this case, the pass frequency band of the variable band pass filter is changed (shifted) in units of segments under the instruction of the segment select signal Dsg, so that the segment signal Ssg corresponding to a desired segment is separated and output out of the intermediate-frequency signal SIF of 6 MHz in frequency band.

The demodulator 6 comprises a so-called analog demodulator and digital demodulator. When supplied with the intermediate-frequency signal San from the analog-TV-specific band pass filter 5a, the demodulator 6 generates a composite signal or a predetermined form of video data from the intermediate-frequency signal San and outputs it as a reproduced signal Srx. When supplied with the segment signal Ssg from the segment selecting band pass filter 5b during the reception of a digital television broadcast, the demodulator 6 generates a composite signal or a predetermined form of video data from the segment signal Ssg and outputs it as the reproduced signal Srx.

In addition, when supplied with the segment signal Ssg from the segment selecting band pass filter 5b during the reception of a digital audio broadcast, the demodulator 6 generates an audio signal from the segment signal Ssg and outputs it as the reproduced signal Srx.

Hence, when the reproduced signal Srx generated by the demodulator 6 is supplied to a monitor and a speaker system, or display means and sound means, users and others can view and listen to the pictures and sounds distributed from broadcast stations.

The signal level detecting unit 7 detects the level (amplitude) of the segment signal Ssg output from the segment selecting band pass filter 5b during the automatic tuning, and compares the detected level with a threshold set in advance. Then, the signal level detecting unit 7 supplies the control unit 9 with a level detecting signal Sd for indicating whether the detected level is higher or lower than the threshold. It also detects the power (root-mean-square value) of the segment signal Ssg and supplies a power detecting signal Srms to the control unit 9. Incidentally, the level detecting signal Sd is supplied to the control unit 9 as a binary signal which shows logic "H" when the detected level is higher than the threshold and logic "L" when the detected level is lower than the threshold.

The foregoing threshold is set in advance for the sake of examining the intensity of the incoming wave during the automatic tuning. The comparison between the level of the segment signal Ssg and the threshold is made irrespective of which the incoming wave in the frequency band of a segment under station detection is, a digital broadcast wave or an analog broadcast wave. That is, no matter what the subject of the station detection may be, the segment signal Ssg obtained from a digital audio broadcast wave, the segment signal Ssg obtained from a digital television broadcast wave, or the segment signal Ssg obtained from an analog television broadcast wave, any segment signal Ssg is compared with the threshold to supply the level detecting signal Sd to the control unit 9 without distinction.

The synchronization detecting unit 8 detects if the segment signal Ssg includes a synchronizing signal.

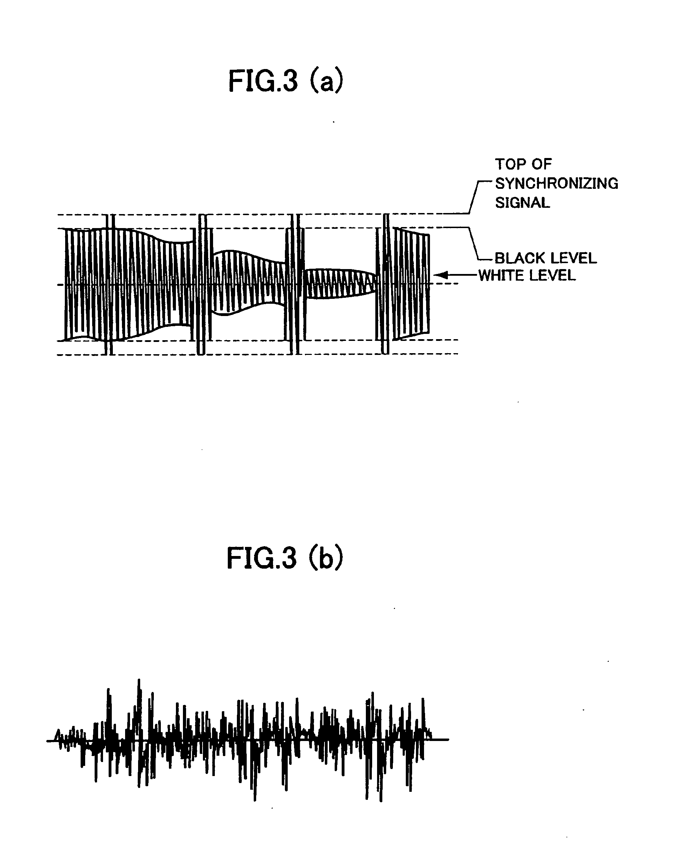

That is, as illustrated in Fig. 3(a), intermediate-frequency signals SIF obtained from analog television broadcast waves prevalent heretofore, such as those of NTSC system, include a synchronizing signal as an inherent signal of analog television broadcast waves. The synchronizing signal is intended to determine the scanning frequency in reproducing pictures and is given a level higher than the black level of the picture signals. In contrast, as illustrated in Fig. 3(b), intermediate-frequency signals SIF obtained in receiving digital audio broadcast waves and digital television broadcast waves do not include such a synchronizing signal.

The synchronization detecting unit 8 then performs synchronization detection on the segment signal Ssg. Detecting a synchronizing signal, the synchronization detecting unit 8 supplies the control unit 9 with a synchronization detecting signal Sync indicating that an analog television broadcast wave is received. Detecting no synchronizing signal, it supplies a synchronization detecting signal Sync indicating that no analog television broadcast wave is received.

Incidentally, the synchronization detecting signal Sync is supplied to the control unit 9 as a binary signal which shows logic "H" when the foregoing synchronizing signal is detected and logic "L" when the synchronizing signal is not detected.

The control unit 9 contains a microprocessor (MPU). This microprocessor executes system programs established in advance, thereby controlling the local oscillator 3, the switching circuit 4, the segment selecting band pass filter 5b, the signal level detecting unit 7, and the synchronization detecting unit 8 during the automatic tuning. The control unit 9 also examines the level detecting signal Sd and the synchronization detecting signal Sync, when supplied from the signal level detecting unit 7 and the synchronization detecting unit 8, and determines what the segment signal Ssg under station detection results from, an analog television broadcast wave, a digital audio broadcast wave, or a digital television broadcast wave.

In other words, the segment selecting band pass filter 5b, the signal level detecting unit 7, and the synchronization detecting unit 8 constitute so-called detecting means. The control unit 9 makes the foregoing determination based on the level detecting signal Sd and the synchronization detecting signal Sync which are obtained by the detecting means when a segment in a channel is under detection.

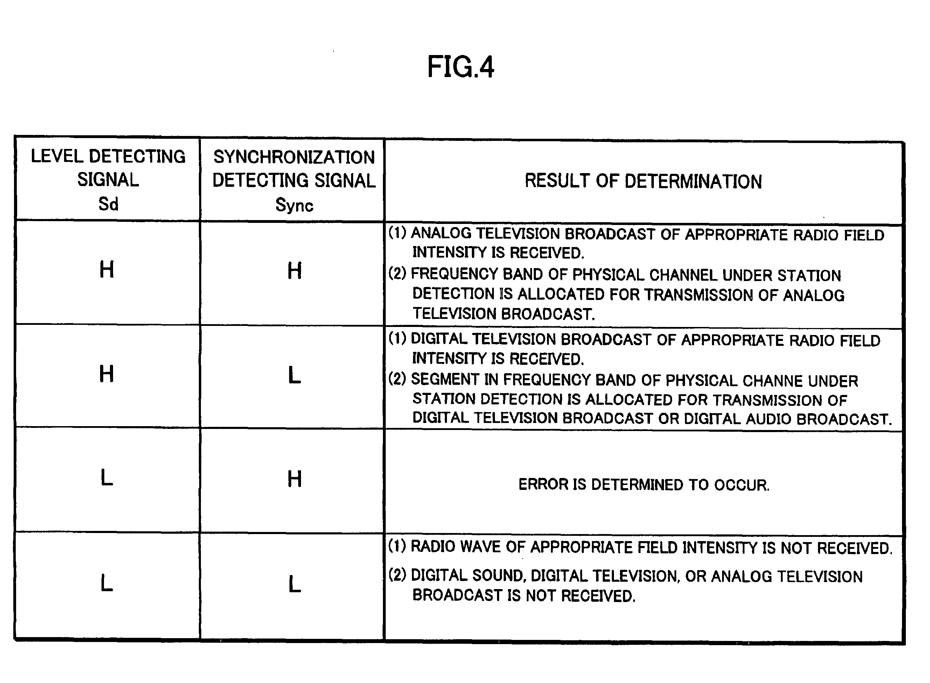

Fig. 4 shows the criteria by which the control unit 9 makes the determination.

Specifically, the control unit 9 specifies the frequency of the local oscillating signal from the local oscillator 3 and selects one band pass filter in the segment selecting band pass filter 5b to designate a physical channel and a segment for station detection. If the level detecting signal Sd and the synchronization detecting signal Sync are both "H" in logic, the control unit 9 determines that an analog television broadcast wave having a radio field intensity suitable for selection as the subject of station detection (i.e., well-receivable) is received, and that the entire frequency band of the physical channel under station detection is allocated for the transmission of an analog television broadcast wave.

Then, frequency data indicating the frequency of the local oscillating signal, channel number data indicating the number of the physical channel (so-called channel number) subjected to the determination, type data indicating that the frequency band of the physical channel is allocated for the transmission of an analog television broadcast wave, and the power detecting signal Srms are stored as determination result data into a nonvolatile semiconductor memory built in the microprocessor.

Now, assume that the control unit 9 specifies the frequency of the local oscillating signal from the local oscillator 3 and selects one band pass filter in the segment selecting band pass filter 5b to designate a physical channel and a segment for station detection, and the level detecting signal Sd shows "H" in logic and the synchronization detecting signal Sync shows "L" in logic. In this case, the control unit 9 determines that a well-receivable digital television broadcast wave or digital audio broadcast wave is received, and that the segments in the frequency band of the physical channel under station detection are allocated for the transmission of a digital television broadcast wave or digital audio broadcast wave(s).

Then, frequency data indicating the frequency of the local oscillating signal, channel and segment number data indicating the channel number and the number of the segment subjected to the determination, type data indicating that the channel and segment number data is allocated for the transmission of a digital television broadcast wave or digital audio broadcast wave, and the power detecting signal Srms are stored as determination result data into the nonvolatile semiconductor memory built in the microprocessor.

If the control unit 9 specifies the frequency of the local oscillating signal from the local oscillator 3 and selects one band pass filter in the segment selecting band pass filter 5b to designate a physical channel and a segment for station detection, and the level detecting signal Sd shows "L" in logic and the synchronization detecting signal Sync shows "H" in logic, then some error is determined to occur. That is, in natural normal reception, the segment signal Ssg to be obtained when an analog television broadcast wave is received should be higher in level than the segment signal Ssg to be obtained when a digital television broadcast wave or digital audio broadcast wave is received. The level detecting signal SD is "L" in logic and the synchronization detecting signal Sync is "H" in logic, however, which means the occurrence of some problem such that the normal reception cannot be achieved due to disturbance or the like. Thus, an error is determined to occur. Then, the channel number and the number of the segment suffering the error detection are excluded from station detection.

If the control unit 9 specifies the frequency of the local oscillating signal from the local oscillator 3 and selects one band pass filter in the segment selecting band pass filter 5b to designate a physical channel and a segment for station detection, and the level detecting signal Sd and the synchronization detecting signal Sync are both "L" in logic, then the control unit 9 determines that a well-receivable wave is not received. That is, it is determined that none of the waves of digital television broadcasting, digital audio broadcasting, and analog television broadcasting is received. The channel number and the number of the segment subjected to the station detection are thus excluded from tuning.

Now, when an instruction to execute the "next tuning" is given from users or others, the control unit 9 performs the foregoing determination processing on the frequency band of the channel number (the number of the physical channel) and the number of the segment to seek a receivable channel next to the one received currently.

When an instruction to execute the "auto presetting" is given from users or others, the control unit 9 performs the foregoing determination processing on the frequency band of the channel number and the number of the segment to seek a receivable channel. Based on the result of detection, the control unit 9 determines the frequency of the local oscillating signal for the next station detection by a predetermined algorithm, and instructs the local oscillator 3 on the frequency determined. It notifies the segment selecting band pass filter 5b of the next band pass filter to select. This determination processing is repeated until the "auto presetting" is completed.

Under the instruction for the "next tuning" or "auto presetting" from users or others, the control unit 9 thus performs the foregoing determination processing to achieve the automatic tuning in a short time. This determination processing will be further detailed in conjunction with the description of operation to be given later.

Although not shown in the drawings, users or others can turn on predetermined control keys arranged on an operating unit of the automatic tuning apparatus or predetermined control keys arranged on a remote controller to instruct the control unit 9 on the "automatic tuning," i.e., the "next tuning" or the "auto presetting."

When control keys arranged on the foregoing operating unit or remote controller, intended for reception channel setting are operated, the frequency of the local oscillating signal from the local oscillator 3 is set so that the radio wave from the reception channel (i.e., broadcast station) designated by the operation is received.

When users or others operate the foregoing operating unit or remote controller to instruct to start the "automatic tuning," the control unit 9 starts station detection from the reception channel of the broadcast station that the users or others are viewing or listening to currently.

For example, assume that the m th physical channel in a UHF frequency band is tuned in when users or others instruct to start the "next tuning" or "auto presetting." The control unit 9 controls the frequency of the local oscillating signal from the local oscillator 3 so that the m th physical channel is initially subjected to station detection. The control unit 9 also controls the segment selecting band pass filter 5b so that the third segment (hereinafter, referred to as "reference segment") in the m th physical channel initially undergoes station detection.

When the "auto presetting" is instructed of from users or others and is performed, it follows that data indicating the aforementioned power detecting signals Srms, channel numbers, and segment numbers is stored and retained, along with others, in the semiconductor memory of the microprocessor. The control unit 9 then makes comparison on the individual power detecting signals Srms to determine channel numbers and segment numbers which are best suited to reception. Moreover, based on the data of these determined channel numbers and segment numbers, a vehicle-mounted television set or navigation system equipped with, for example, a monitor capable of picture display and a speaker system can assign and register the channel numbers and segment numbers to a plurality of channel selection switches arranged on its control panel unit. In this case, users or others have only to turn on the registered channel selection switches to tune to desired broadcast stations through one-touch operation.

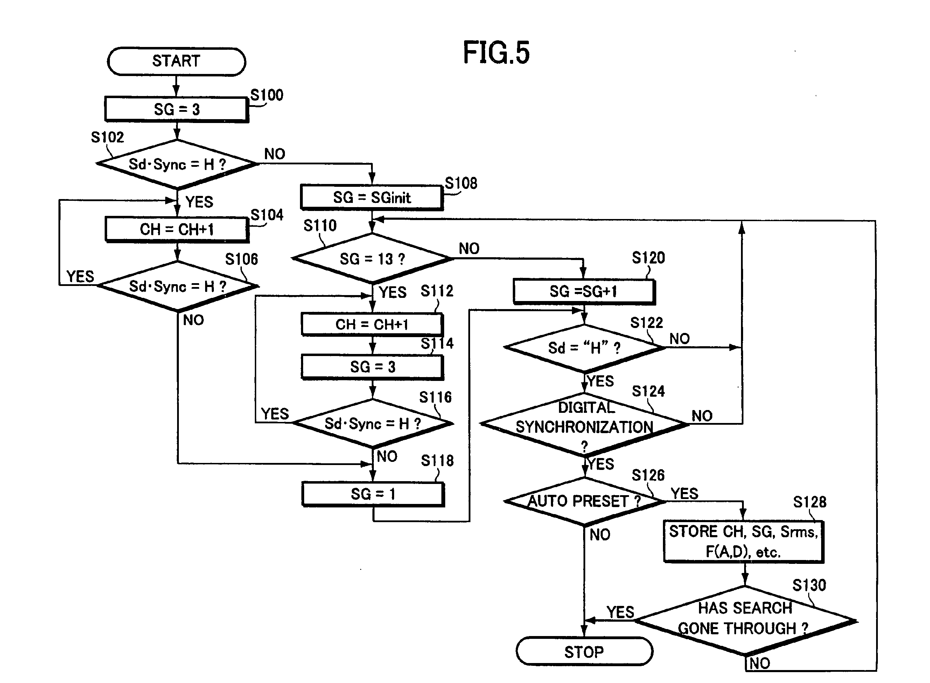

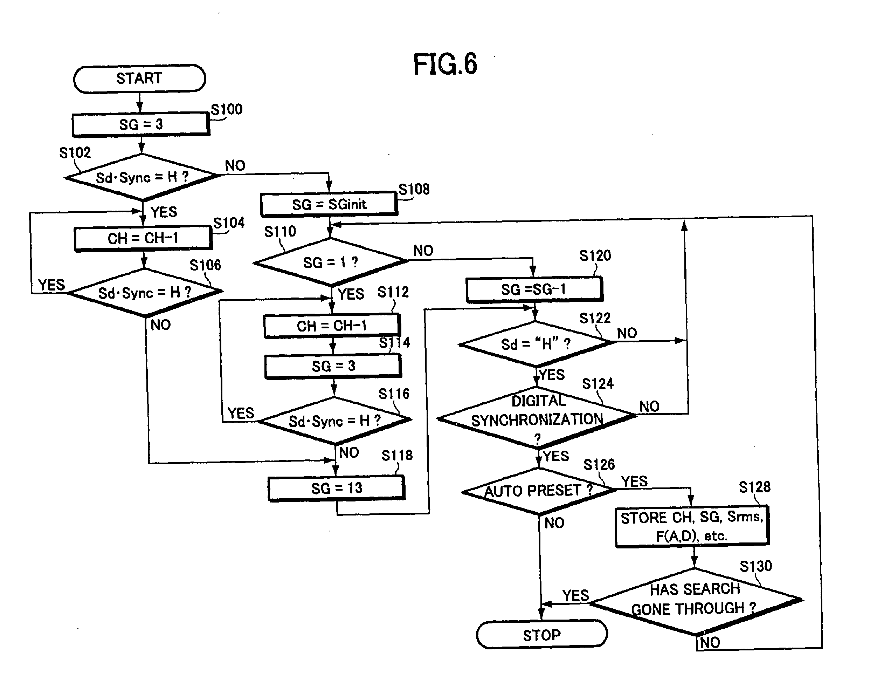

Now, the operation of the automatic tuning apparatus having such a configuration will be described with reference to Figs. 5-10. Fig. 5 is a flowchart for explaining the operation of automatic tuning to be performed under the control of the control unit 9. Fig. 6 is a flowchart for explaining the operation of a modified example.

To explain the primary functions of the automatic tuning apparatus, the following description will deal with the operation for situations where the broadcast stations of the digital audio broadcasting allocated within the VHF frequency band and the broadcast stations of the digital television broadcasting allocated within the UHF frequency bands shown in Fig. 11(b) undergo the "next tuning" or "auto presetting."

In Fig. 5, when users or others instruct the control unit 9 to start the "next tuning" or "auto presetting," the automatic tuning is started under the control of the control unit 9.

Initially, at step S100, the frequency of the local oscillating signal from the local oscillator 3 is set by the channel select signal Dch for the sake of initialization to the channel number CH which is tuned in before the automatic tuning is started by the users or others. Moreover, the third band pass filter BPFsg3 of the segment selecting band pass filter 5b is exclusively turned on by the segment select signal Dsg in order that the number of the reference segment within the channel number CH in question, i.e., the third segment number SG (= 3) is initially subjected to station detection.

Here, since the third band pass filter BPFsg3 is turned on, the synchronizing signal can be detected properly if the channel number CH in question is allocated for the transmission of an analog television broadcast wave.

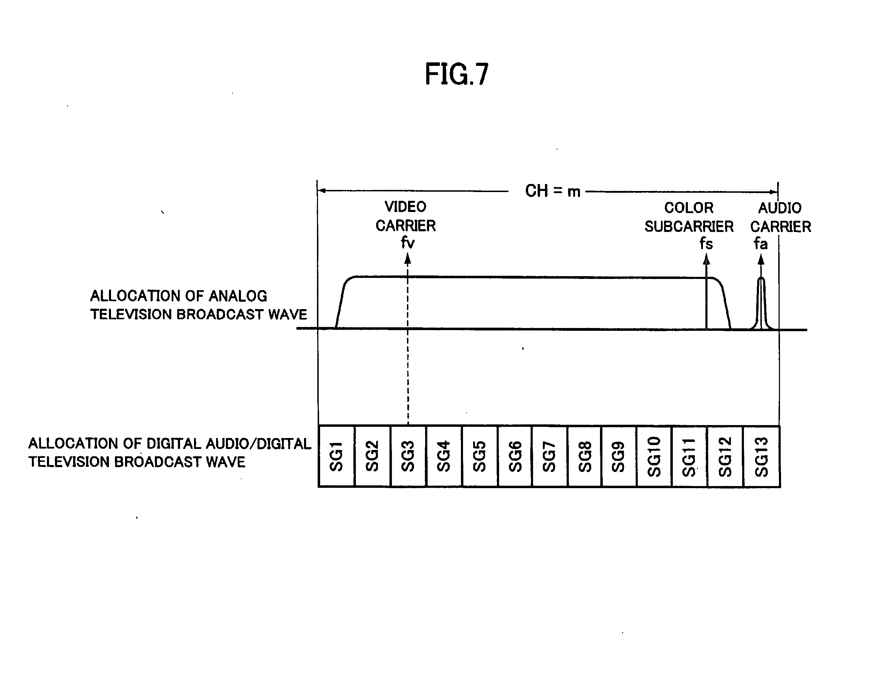

More specifically, as illustrated in Fig. 7 where the tuned channel number CH is the m th physical channel, the frequency fv of a video carrier falls on the frequency position corresponding to the third segment SG3 in the analog television broadcast wave of 6 MHz in frequency band. Thus, the third band pass filter BPFsg3 of the segment selecting band pass filter 5b is exclusively turned on to select the third segment number SG (= 3). This establishes an optimum state for detecting the synchronizing signal of the analog television broadcast wave. That is, the segment SG3 is set initially since it covers the frequency on which the inherent signal of analog television broadcast waves, or the synchronizing signal, will fall if the physical channel contains an analog broadcast wave.

Next, at step S102, the signal level detecting unit 7 and the synchronization detecting unit 8 perform level detection and synchronization detection on the segment signal Ssg. In addition, the control unit 9 performs an AND operation between the level detecting signal Sd and the synchronization detecting signal Sync, and determines to which of the criteria shown in Fig. 4 the result of the AND operation applies. Specifically, if the AND operation results in logic "H," it is determined that a well-receivable analog television broadcast wave is received. The processing moves to step S104. On the other hand, if the AND operation results in logic "L" (if "NO"), the processing moves to step S108.

At step S104, the data of the power detecting signal Srms and the channel and segment numbers mentioned above is stored, along with others, into the semiconductor memory, followed by the addition of "1" to the current channel number CH. To name a concrete example, when the current channel number CH is "m", the addition of "1" updates the channel number CH to be subjected to the next determination as "m + 1".

Next, at step S106, the frequency of the local oscillating signal from the local oscillator 3 is set by the channel select signal Dch so as to set the channel number CH updated at step S104. The third band pass filter BPFsg3 of the segment selecting band pass filter 5b is kept turned on.. Then, the signal level detecting unit 7 and the synchronization detecting unit 8 perform level detection and synchronization detection on the segment signal Ssg. In addition, the control unit 9 performs an AND operation between the level detecting signal Sd and the synchronization detecting signal Sync, and determines to which of the criteria shown in Fig. 4 the result of the AND operation applies. Specifically, if the AND operation results in logic "H", it is determined that a well-receivable analog television broadcast wave is received at the updated channel number CH again. The processing moves to step S104 and repeats in the same fashion.

On the other hand, if the AND operation results in logic "L" at step S106 (if "NO"), it is determined that an analog television broadcast wave may not be received at the updated channel number CH. The processing then moves to step S118.

Consequently, in the processing of steps S102 to S106, if the AND operation results in logic "H" and the reception of an analog television broadcast wave is determined, a jump occurs so that the next channel number CH is subjected to determination. Here, as schematically shown in Fig. 7, only the reference segments (third segments) in the respective physical channels undergo the determination with the rest of the segments excluded from seeks.

Hence, as long as analog television broadcast waves are received, the individual segments at the channel numbers CH are not all subjected to seeks as have been heretofore. This allows a quick shift to the processing for seeking a digital audio broadcast wave or digital television broadcast wave.

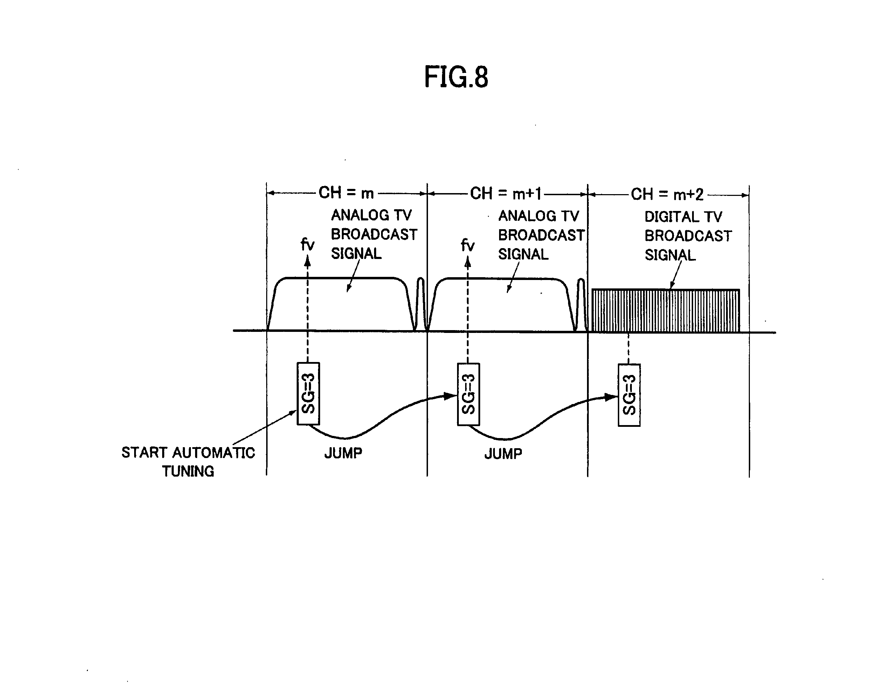

Fig. 8 shows a concrete example where channel numbers CH = m and CH = m + 1 in a UHF frequency band are allocated for the transmission of analog television broadcast waves, and a channel number CH = m + 2 is allocated for the transmission of a digital television broadcast wave.

When adjoining physical channels are consecutively allocated for analog television broadcasting as seen above, only the reference segments (SG = 3) in the respective physical channels for analog television broadcasting undergo determination before a jump to a physical channel for digital television broadcasting. The broadcast station of digital television broadcasting can thus be sought in a short time.

Aside from the UHF frequency bands, the same jump processing as shown in Fig. 8 can occur in the VHF frequency band when channel numbers CH allocated for the transmission of analog television broadcast waves are subjected to determination. In the case of the VHF frequency band, broadcast stations of digital audio broadcasting can be sought in a short time.

Incidentally, when the reception of an analog television broadcast wave is denied at step S106 and the processing moves to step S118, seeks are started for a digital audio broadcast wave or digital television broadcast wave. This seek operation will be described later.

Now, if the processing moves from the foregoing step S102 to step S108, the segment selecting band pass filter 5b is controlled by the segment select signal Dsg so that a segment number SGinit the last tuned by the foregoing users or others in the channel number CH is subjected to station detection.

More specifically, if the station detection on the reference segment (third segment) of the first channel number CH at the foregoing step S102 detects no synchronizing signal, it is determined that the first channel CH may be allocated for the transmission of digital audio broadcast waves or a digital television broadcast wave. The processing then moves to step S108.

When it is determined that the first channel CH may be allocated for the transmission of digital audio broadcast waves or a digital television broadcast wave, the segment number SGinit in the channel number CH which is tuned in before the users or others instruct to start the automatic tuning is set as the first segment number SG to be subjected to station detection. That is, at the foregoing step S102, the reference segment (third segment) is adopted to check for the reception of an analog television broadcast wave. At step S108, in contrast, the segment number SGinit having been tuned in the channel number CH is employed because of the determination that an analog television broadcast wave may not be received. This narrows down the segments in directing station detection to digital audio broadcast waves or digital television broadcast waves. As a result, a reduction can be made of the time required for the automatic tuning.

Next, at step S110, whether or not the set segment number SG is equivalent to the thirteenth segment is determined. If it is the thirteenth segment, the processing moves to step S112. If not, it is determined that the set segment number SG falls within the range of the first to twelfth segments. The processing then moves to step S120.

At step S120, "1" is added to the segment number SG. The segment selecting band pass filter 5b is controlled by the segment select signal Dsg so that the next segment number SG (= SG + 1) undergoes station detection. Here, the current channel number CH is kept as is. As a result, the segment number SG alone is updated within the current channel number CH.

Next, at step S122, the signal level detecting unit 7 performs level detection on the segment signal Ssg. If the level detecting signal Sd is "H" in logic, it is determined that a well-receivable digital audio broadcast wave or digital television broadcast wave is received. The processing moves to step S124. On the other hand, if the level detecting signal Sd is "L" in logic, the processing returns to step S110 to continue.

At step S124, the control unit 9 examines the result of the digital synchronization determination performed by the demodulator 6. If the result of the digital synchronization determination confirms that the segment signal Ssg is properly decodable, the processing moves to step S126. In the absence of the confirmation, the processing returns to step S110 to continue.

That is, at steps S122 and S124, a determination of a well-receivable state is given if the received broadcast wave has an appropriate level and the demodulator 6 produces a proper decoding result.

At step S126, the type of the "automatic tuning" instructed from the users or others is checked.

If the "auto presetting" is instructed, the processing moves to step S128.

On the other hand, if the "auto presetting" is not instructed (in other words, when the "next tuning" is instructed), the automatic tuning is ended. That is, up to the processing of the foregoing step S124, a well-receivable digital audio broadcast wave or digital television broadcast wave is received, thereby achieving the aim of the "next tuning" for seeking the next reception channel. Hence, the automatic tuning is ended unless the "auto presetting" is instructed.

When the "auto presetting" is instructed and the processing enters step S128, the channel number CH and segment number SG at which a well-receivable digital audio broadcast wave or digital television broadcast wave is determined to be received, the power detecting signal Srms, and identification data F(A,D) for indicating whether the received broadcast wave is a digital audio broadcast wave or digital television broadcast wave, are stored into the semiconductor memory. This means that information on a single broadcast station sought is stored into the semiconductor memory.

Then, at step S130, it is determined if all the well-receivable broadcast stations in the VHF and UHF frequency bands have been searched for. If not yet, the processing repeats from step S110. If the search has gone through, the automatic tuning is ended.

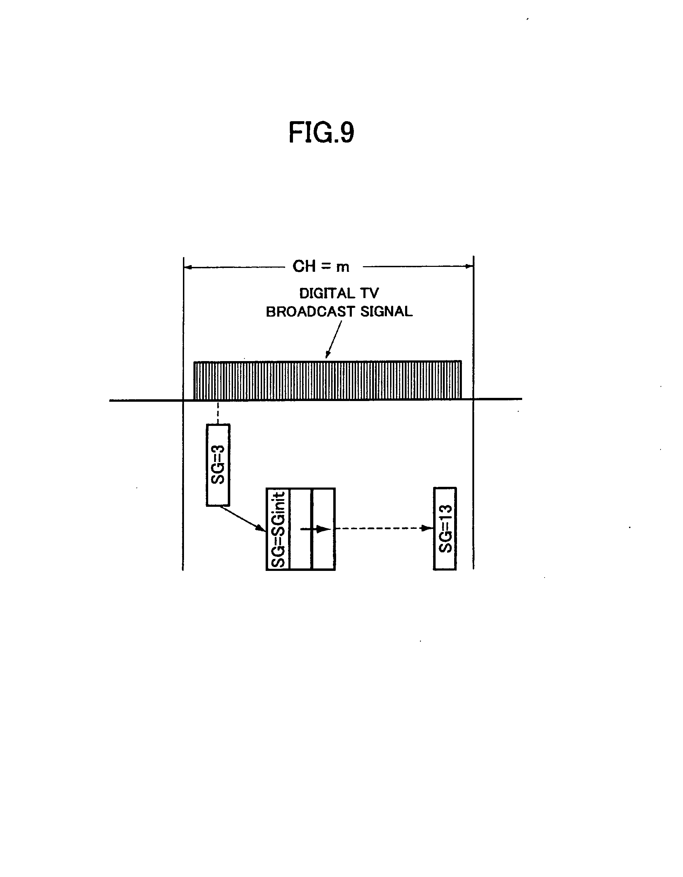

Such repetition of the processing of steps S110 and S120-S130 performs, as schematically shown in Fig. 9, station detection across the segment numbers for transmitting a digital television broadcast wave falling with the range of the segment number SGinit and the segment number SG (= 13) in a channel number CH in the UHF frequency bands. When a channel number CH in the VHF frequency band is put under station detection, the station detection is also performed as with Fig. 9, i.e., across the segment numbers for transmitting digital audio broadcast waves falling within the range of the segment number SGinit and the segment number SG (= 13).

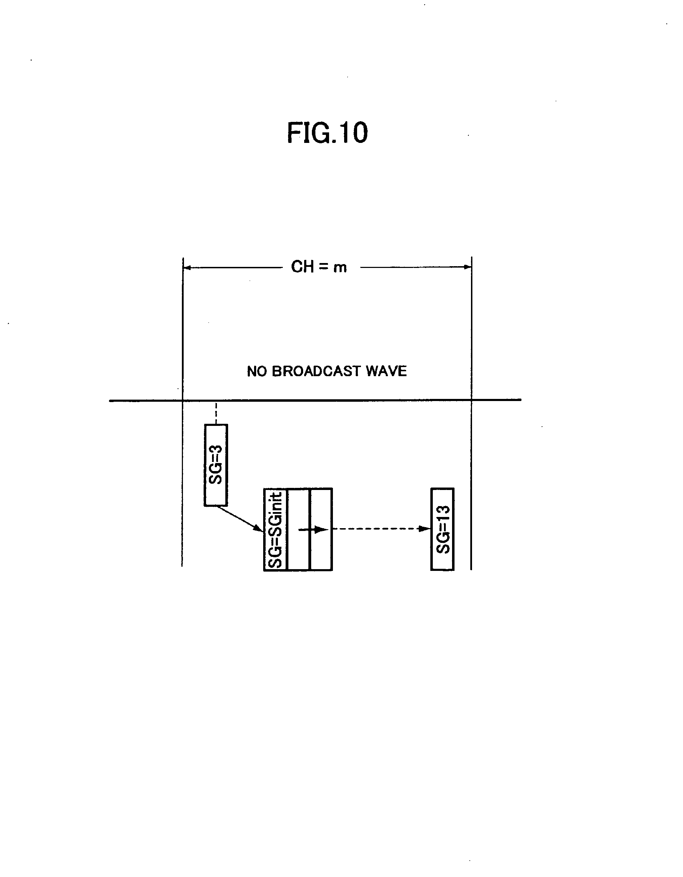

Furthermore, as shown in Fig. 10, even when the channel number CH under station detection is not used to transmit a digital audio broadcast wave or digital television broadcast wave, the station detection is also performed across the segment numbers in the range of the segment number SGinit and the segment number SG (= 13).

Now, description will be given of the operation for the case where the processing moves from the foregoing step S110 to step S112.

That is, at step 110, if station detection reaches the thirteenth segment number SG (= 13), the processing moves to step S112.

At step S112, "1" is added to the current channel number CH. The frequency of the local oscillating signal from the local oscillator 3 is set by the channel select signal Dch so that the added channel number CH (= CH + 1) is subjected to station detection.

Next, at step S114, the segment selecting band pass filter 5b is controlled by the segment select signal Dsg so that the third segment number SG (= 3) in the added channel number CH (= CH + 1) is adopted. Here, the third segment number SG (= 3) is adopted for the reason that the physical channel at the added channel number CH (= CH + 1) may be used to transmit an analog television broadcast wave.

Next, at step S116, the signal level detecting unit 7 and the synchronization detecting unit 8 perform level detection and synchronization detection on the segment signal Ssg. In addition, the control unit 9 performs an AND operation between the level detecting signal Sd and the synchronization detecting signal Sync, and determines to which of the criteria shown in Fig. 4 the result of the AND operation applies.

Specifically, if the AND operation results in logic "H", it is determined that a well-receivable analog television broadcast wave is received. The processing moves to step S112 and repeats in the same fashion. On the other hand, if the AND operation results in logic "L" at step S116 (if "NO"), it is determined that a digital television broadcast or digital audio broadcast may be received. The processing then moves to step S118.

The processing of steps S112 to S116 is repeated in this way. When an analog television broadcast wave is received, a jump occurs so that the next channel number CH is subjected to station detection, as with steps S102, S104, and S106 described with reference to Fig. 8. That is, only the reference segments (third segments) in the respective physical channels undergo determination with the rest of the segments excluded from seeks. Hence, as long as analog television broadcast waves are received, the individual segments at the channel numbers CH are not all subjected to seeks as have been heretofore. This allows a quick shift to the processing for seeking a digital audio broadcast wave or digital television broadcast wave.

Then, if the reception of an analog television broadcast wave is denied at step S116 or if the reception of an analog television broadcast wave is denied at the foregoing step S106, the processing moves to step S118.

At step S118, the segment selecting band pass filter 5b is controlled by the segment select signal Dsg so that the first segment SG (= 1) in the channel number CH undergoes station detection with no change in the channel number CH currently under station detection. Then, the processing moves to step S122.

Subsequently, the processing at and after the foregoing step S122 continues to perform station detection across the segment numbers in the range of the first segment number SG (= 1) and the thirteenth segment number SG (= 13).

Consequently, the automatic tuning apparatus of the present embodiment, if the third segment SG (= 3) in a channel number undergoes station detection and shows logic "H" in both the level detecting signal Sd and the synchronization detecting signal Sync, determines that an analog television broadcast wave is received. The automatic tuning apparatus then makes a jump to subject the next channel number to station detection, thereby allowing a reduction in the time required for the automatic tuning.

As having been described, the automatic tuning apparatus adds "1" to the channel number CH at steps S104 and S112 so that the channel number CH to be subjected to station detection shifts to higher frequencies. At step S120, "1" is also added to the segment number SG so that the segment number SG to be subjected to station detection also shifts to higher frequencies.

To the contrary, however, "1" may be subtracted from the channel number CH so that the channel number CH to undergo station detection shifts to lower frequencies. Besides, "1" may be subtracted from the segment number SG so that the segment number SG to undergo station detection also shifts to lower frequencies.

Fig. 6 is a flowchart showing the operation for the case where the channel number CH and the segment number SG to be subjected to station detection shift to lower frequencies. In Fig. 6, the processes identical or equivalent to those of Fig. 5 are designated by the same step numbers.

To name the differences from Fig. 5, steps S104 and S112 of Fig. 6 include an operation of CH = CH - 1. This shifts the channel number CH to be subjected to station detection to lower frequencies. Besides, step S120 includes an operation of SG = SG - 1. At step S110, it is determined if the segment number SG under station detection reaches the first segment number. At step S118, the segment number to be subjected to station detection is set to the thirteenth segment number SG (= 13) before the segment number SG for station detection is moved to lower frequencies.

Even in performing the operation shown in Fig. 6, if the third segment SG in a channel number undergoes station detection and shows logic "H" in both the level detecting signal Sd and the synchronization detecting signal Sync, it is determined that an analog television broadcast wave is received. Then, a jump occurs to subject the next channel number to station detection, which allows a reduction in the time required for the automatic tuning.

Incidentally, in the present embodiment, the synchronizing signal is detected as an inherent signal to be included in analog television broadcast waves, and is used to determine if an analog television broadcast signal is received. Nevertheless, other inherent signals capable of extracting characteristics of analog television broadcast waves may be detected.

For example, a color sub-carrier or an audio carrier included in analog television broadcast waves may be detected as the inherent signal. In the foregoing case of detecting the synchronizing signal, the third segment number which corresponds to the frequency fv of the synchronizing signal as shown in Fig. 7 is the first segment to undergo station detection. When the color sub-carrier is to be detected, however, the segment corresponding to the frequency fs of the color sub-carrier initially undergoes station detection. If the color sub-carrier is detected, a jump occurs so that the next channel number is subjected to station detection. When the audio carrier is to be detected, the segment corresponding to the frequency fa of the audio carrier initially undergoes station determination. If the audio carrier is detected, a jump occurs so that the next channel number is subjected to station detection.

Since this detection of the color sub-carrier or audio carrier also involves a jump for subjecting the next channel number to station detection, it is possible to reduce the time required for the automatic tuning.

In the automatic tuning apparatus of the present embodiment, the frequency of the local oscillating signal set by the local oscillator 3 is changed to generate an intermediate-frequency signals SIF for each physical channel. The intermediate-frequency signal SIF having a frequency band of 6 MHz is then divided into 0.4-MHz segments through a plurality of narrow-band-pass type band pass filters BPFsg1-BPFsg13 which constitute the segment selecting band pass filter 5b. However, the present invention is not limited thereto.

Specifically, the segment selecting band pass filter 5b may consist of a single 0.4-MHz band pass filter of narrow-band-pass type. In this case, the frequency of the local oscillating signal from the local oscillator 3 is varied in accordance with the carrier frequency of each segment. According to such configuration, the intermediate-frequency signal SIF output from the frequency converter 4 has only to be passed through the 0.4-MHz band pass filter of narrow-band-pass type before the segment signal Ssg corresponding to the physical channel and segment to be sought is output from the segment selecting band pass filter 5b. In addition, the segment selecting band pass filter 5b can be simplified in configuration and reduced in size.

The operation examples described with reference to Figs. 5 and 6 have dealt with the cases where the "next tuning" or "auto presetting" is performed on broadcast stations of digital television broadcasting or digital audio broadcasting. Nevertheless, the "next tuning" or "auto presetting" may be performed on broadcast stations of analog television broadcasting.

More specifically, assume that an instruction for the "next tuning" is issued from users or others and the synchronizing signal is detected from the third segment, or reference segment, at step S106 of Fig. 5 or 6. Considering that a next well-receivable channel (broadcast station) is found, the seek can be terminated to realize the "next tuning" on analog television broadcasting.

Now, assume that an instruction for the "auto presetting" is issued from users or others and the synchronizing signal is detected from the third segment, or reference segment, at steps S106 and S116 of Fig. 5 or 6. Then, considering that a next well-receivable channel (broadcast station) is found, the information on the found physical channel can be stored into the semiconductor memory of the control unit 9 to achieve the "auto presetting" on analog television broadcasting. Additionally, when such "auto presetting" is achieved, it follows that the foregoing "auto presetting" on digital television broadcasting and digital audio broadcasting is accompanied with the "auto presetting" on analog television broadcasting. The "auto presetting" can thus be performed without distinction between digital broadcasting and analog broadcasting. As a result, it is possible to provide an automatic tuning apparatus well equipped for multimedia.

As has been described, the automatic tuning apparatus of the present invention, if an inherent signal to be included in analog broadcast waves is detected during tuning, directs tuning operations to a physical channel free of analog broadcast wave. This eliminates the need for fine detections within physical channels, thereby allowing a reduction in the time required for tuning.

## Claims

1. An automatic tuning apparatus comprising:
receiving means (ANT) for receiving a plurality of analog and digital broadcast waves, wherein said broadcast waves include a plurality of physical channels having a first frequency band width, respectively, in which each physical channel is formed from a plurality of segments having a second frequency band width narrower than said first frequency band width, one of the analog broadcast waves being allocated to one of the physical channels, and also at least one of the digital broadcast waves being allocated to another physical channel; and
frequency converting means (2) for converting a reception frequency signal into a predetermined intermediate-frequency signal,
**characterized by**
single segment selecting means (5b) for outputting a signal of segment-frequency band selected from the intermediate-frequency signal irrespective of the analog broadcast waves or the digital broadcast waves;
signal-level detecting means (7) for detecting an output level of signal of each segment-frequency band from said segment selecting means;
analog broadcast waves detecting means (8) for detecting a signal of a predetermined segment-frequency band including features of the analog broadcast waves, and for outputting a power level thereof; and
control means (9) for controlling the reception frequency of said frequency converting means and the frequency band of said segment selecting means;
wherein said control means first instructs the output of signal in the predetermined segment-frequency band to said segment selecting means when receiving an instruction of starting an automatic tuning, and then determines whether the analog broadcast waves are present or not, based on the output level from said signal-level detecting means and the power level from said analog broadcast waves detecting means; and
said control means further determines whether the digital broadcast waves are present or not, based on the output level from said signal-level detecting means, through making said segment selecting means select a segment adjoining the segment received just before receiving said instruction of the automatic tuning and one after another from said adjoining segment, when no existence of analog broadcast waves is determined.

2. The automatic tuning apparatus according to claim 1, wherein said control means (9) controls a reception frequency of the frequency converting means (2) to be changed to a frequency of a physical channel adjoining said physical channel received just before receiving said instruction of automatic tuning when an existence of analog broadcast waves is determined.

3. The automatic tuning apparatus according to claim 2, wherein when no existence of analog broadcast waves in a physical channel of said changed reception frequency is determined, said control means (9) makes said segment selecting means (5b) select an end segment and one after another from said end segment within said physical channel.

4. The automatic tuning apparatus according to claim 1, wherein said control means (9)controls the reception frequency of the frequency converting means (2) to be changed to a frequency of a physical channel adjoining said physical channel received just before receiving said instruction of automatic tuning when said segment selecting means (5b) completes tuning operations on all the segments within said physical channel.

5. The automatic tuning apparatus according to claim 2 or 4, wherein selected objects of said control means (9) are all the physical channels when said instruction is for an auto presetting.

6. The automatic tuning apparatus according to claim 1, wherein the feature of said analog broadcast waves is in a synchronizing signal of the analog broadcast.

## Patentansprüche

1. Automatische Tuner-Vorrichtung, die Folgendes umfasst:
eine Empfangseinrichtung (ANT) zum Empfangen mehrerer analoger und digitaler Rundfunkwellen, wobei die Rundfunkwellen mehrere physikalische Kanäle mit jeweils einer ersten Frequenzbandbreite umfassen, wobei jeder physikalische Kanal aus mehreren Segmenten mit einer zweiten Frequenzbandbreite aufgebaut ist, die schmäler ist als die erste Frequenzbandbreite, wobei eine der analogen Rundfunkwellen einem der physikalischen Kanäle zugeteilt ist und auch mindestens eine der digitalen Rundfunkwellen dem anderen physikalischen Kanal zugeteilt ist; und
eine Frequenzwandlereinrichtung (2) zum Umwandeln eines Empfangsfrequenzsignals in ein vorbestimmtes Zwischenfrequenzsignal,
**gekennzeichnet durch**
eine Einzelsegmentwahleinrichtung (5) zum Ausgeben eines Signals eines Segmentfrequenzbands, das ungeachtet der analogen Rundfunkwellen oder der digitalen Rundfunkwellen aus dem Zwischenfrequenzsignal ausgewählt wird;
eine Signalpegelerfassungseinrichtung (7) zum Erfassen eines Signalausgangspegels jedes Segmentfrequenzbands aus der Segmentwahleinrichtung;
eine Erfassungseinrichtung (8) für analoge Rundfunkwellen zum Erfassen eines Signals eines vorbestimmten Segmentfrequenzbands, das Merkmale der analogen Rundfunkwellen enthält, und zum Ausgeben eines Leistungspegels von diesem; und
eine Regeleinrichtung (9) zum Regeln der Empfangsfrequenz der Frequenzwandlereinrichtung und des Frequenzbands der Segmentwahleinrichtung; wobei die Regeleinrichtung die Ausgabe von Signalen im vorbestimmten Segmentfrequenzband an die Segmentwahleinrichtung erst anweist, wenn eine Anweisung zum Starten eines automatischen Abstimmvorgangs eingeht, und dann auf Grundlage des Ausgangspegels aus der Signalpegelerfassungseinrichtung und des Leistungspegels aus der Erfassungseinrichtung für analoge Rundfunkwellen bestimmt, ob die analogen Rundfunkwellen vorhanden sind oder nicht; und
die Regeleinrichtung darüber hinaus auf Grundlage des Ausgangspegels aus der Signalpegelerfassungseinrichtung bestimmt, ob die digitalen Rundfunkwellen vorhanden sind oder nicht, indem die Segmentwahleinrichtung dazu veranlasst wird, ein Segment, das an das Segment angrenzt, das genau vor dem Erhalt der Anweisung des automatischen Abstimmvorgangs empfangen wurde, und ein Segment nach dem anderen ab dem angrenzenden Segment auszuwählen, wenn kein Vorhandensein analoger Rundfunkwellen bestimmt wird.

2. Automatische Tuner-Vorrichtung nach Anspruch 1, wobei die Regeleinrichtung (9) eine Empfangsfrequenz der Frequenzwandlereinrichtung (2) regelt, die auf eine Frequenz eines physikalischen Kanals umgestellt werden soll, der an den physikalischen Kanal angrenzt, der genau vor dem Erhalt der Anweisung eines automatischen Abstimmvorgangs empfangen wurde, wenn ein Vorhandensein analoger Rundfunkwellen bestimmt wird.

3. Automatische Tuner-Vorrichtung nach Anspruch 2, wobei, wenn kein Vorhandensein analoger Rundfunkwellen in einem physikalischen Kanal mit der umgestellten Empfangsfrequenz bestimmt wird, die Regeleinrichtung (9) die Segmentwahleinrichtung (5b) dazu veranlasst, ein Endsegment und ein Segment nach dem anderen ab dem Endsegment in dem physikalischen Kanal auszuwählen.

4. Automatische Tuner-Vorrichtung nach Anspruch 1, wobei die Regeleinrichtung (9) die Empfangsfrequenz der Frequenzwandlereinrichtung (2) regelt, die auf eine Frequenz eines physikalischen Kanals umgestellt werden soll, der an den physikalischen Kanal angrenzt, der genau vor dem Erhalt der Anweisung eines automatischen Abstimmvorgangs empfangen wurde, wenn die Segmentwahleinrichtung (5b) Abstimmvorgänge an allen Segmenten in dem physikalischen Kanal abschließt.

5. Automatische Tuner-Vorrichtung nach Anspruch 2 oder 4, wobei es sich bei ausgewählten Objekten der Regeleinrichtung (9) um alle physikalischen Kanäle handelt, wenn die Anweisung für eine automatische Voreinstellung gilt.

6. Automatische Tuner-Vorrichtung nach Anspruch 1, wobei das Merkmal der analogen Rundfunkwellen sich in einem Synchronisationssignal des analogen Rundfunks befindet.

## Revendications

1. Appareil d'accord automatique comportant :
des moyens de réception (ANT) pour recevoir une pluralité d'ondes de diffusion analogique et numérique, dans lequel lesdites ondes de diffusion incluent une pluralité de canaux physiques ayant une première largeur de bande de fréquences, respectivement, chaque canal physique étant formé d'une pluralité de segments ayant une seconde largeur de bande de fréquences plus étroite que ladite première largeur de bande de fréquences, une desdites ondes de diffusion analogique étant allouée à un des canaux physiques, et également au moins une des ondes de diffusion numérique étant allouée à un autre canal physique, et
des moyens de conversion de fréquence (2) pour convertir un signal de fréquence de réception en un signal de fréquence intermédiaire prédéterminé,
**caractérisé par**
des moyens de sélection de segment unique (5b) pour délivrer en sortie un signal de bande de fréquences de segment sélectionné parmi le signal de fréquence intermédiaire que ce soient les ondes de diffusion analogique ou les ondes de diffusion numérique,
des moyens de détection de niveau de signal (7) pour détecter un niveau de sortie de signal de chaque bande de fréquences de segment desdits moyens de sélection de segment,
des moyens de détection d'ondes de diffusion analogique (8) pour détecter un signal d'une bande de fréquences de segment prédéterminée incluant des propriétés des ondes de diffusion analogique, et pour délivrer en sortie un niveau de puissance de celles-ci, et
des moyens de commande (9) pour commander la fréquence de réception desdits moyens de conversion de fréquence et la bande de fréquences desdits moyens de sélection de segment,
dans lequel lesdits moyens de commande ordonnent tout d'abord la sortie du signal dans la bande de fréquences de segment prédéterminée auxdits moyens de sélection de segment lors de la réception d'une instruction pour commencer un accord automatique, et déterminant ensuite si les ondes de diffusion analogique sont présentes ou non, sur la base du niveau de sortie desdits moyens de détection de niveau de signal et du niveau de puissance desdits moyens de détection d'ondes de diffusion analogique, et
lesdits moyens de commande déterminent de plus si les ondes de diffusion numérique sont présentes ou non, sur la base du niveau de sortie desdits moyens de détection de niveau de signal, en amenant lesdits moyens de sélection de segment à sélectionner un segment contigu au segment reçu juste avant la réception de ladite instruction de l'accord automatique et un segment après l'autre depuis ledit segment contigu, lorsqu'aucune existence d'ondes de diffusion analogique n'est déterminée.

2. Appareil d'accord automatique selon la revendication 1, dans lequel lesdits moyens de commande (9) commandent une fréquence de réception des moyens de conversion de fréquence (2) pour la changer en une fréquence d'un canal physique contiguë audit canal physique reçu juste avant la réception de ladite instruction d'un accord automatique lorsque l'existence d'ondes de diffusion analogique est déterminée.

3. Appareil d'accord automatique selon la revendication 2, dans lequel, lorsqu'aucune existence d'ondes de diffusion analogique dans un canal physique de ladite fréquence de réception changée n'est déterminée, lesdits moyens de commande (9) amènent lesdits moyens de sélection de segment (5b) à sélectionner un segment d'extrémité et un segment après l'autre depuis ledit segment d'extrémité à l'intérieur dudit canal physique.

4. Appareil d'accord automatique selon la revendication 1, dans lequel lesdits moyens de commande (9) commandent la fréquence de réception des moyens de conversion de fréquence (2) à changer en une fréquence d'un canal physique contigu audit canal physique reçu juste avant réception de ladite instruction d'accord automatique lorsque lesdits moyens de sélection de segment (5b) achèvent des opérations d'accord sur la totalité des segments à l'intérieur dudit canal physique.

5. Appareil d'accord automatique selon la revendication 2 ou 4, dans lequel des objets sélectionnés desdits moyens de commande (9) sont tous les canaux physiques lorsque ladite instruction est un auto-préréglage.

6. Appareil d'accord automatique selon la revendication 1, dans lequel la propriété desdites ondes de diffusion analogique se trouve dans un signal de synchronisation de la diffusion analogique.
